# FASCICULE DE BREVET EUROPEEN

(11) **EP 1 880 249 B1**
(45) Date de publication et mention de la délivrance du brevet: **23.05.2012**
(21) Numéro de dépôt: 06754963.4
(22) Date de dépôt: 02.05.2006
(51) Int. Cl.: G03F 7/20, G02B 17/08

(54) **SYSTEME OPTIQUE POUR UN DISPOSITIF DE LITHOGRAPHIE**
OPTISCHES SYSTEM FÜR EINE LITHOGRAPHIEVORRICHTUNG
OPTICAL SYSTEM FOR A LITHOGRAPHIC DEVICE

(30) Priorité: 29.04.2005 FR 0504362; 22.08.2005 FR 0508657
(43) Date de publication de la demande: 23.01.2008
(73) Titulaire: SAGEM Défense Sécurité, 75015 Paris (FR)
(72) Inventeur: TANNE, Jean-François, F-75015 Paris (FR); MICHELIN, Jean-Luc, F-75015 Paris (FR); GEYL, Roland, F-75015 Paris (FR)
(74) Mandataire: Texier, Christian
(86) Numéro de dépôt international: PCT/EP2006/061987
(87) Numéro de publication internationale: WO 2006/117378

(56) Documents cités:
- US-A- 4 103 989
- US-A- 4 171 871
- US-A1- 2004 239 893

## Description

### DOMAINE TECHNIQUE GENERAL

L'invention concerne un système optique pour un dispositif de photolithographie.

La photolithographie est généralement utilisée pour la fabrication de circuits intégrés avec une résolution de l'ordre du dixième de micromètre pour les applications de haute performance.

Cependant, certaines applications ne nécessitent toutefois pas ce type de précision et se contentent de résolutions de lithographie de l'ordre de 1 à quelques micromètres. On peut citer notamment, l'utilisation de la photolithographie pour la réalisation des plots d'interconnection et de soudure pour les circuits électroniques multicouches dans lesquels des plaques de circuits sont superposées les unes aux autres. L'avantage de tels circuits est qu'ils permettent la conception de puces électroniques complexes et performantes par la superposition de puces simples, chaque puce étant facile à concevoir et fabriquer.

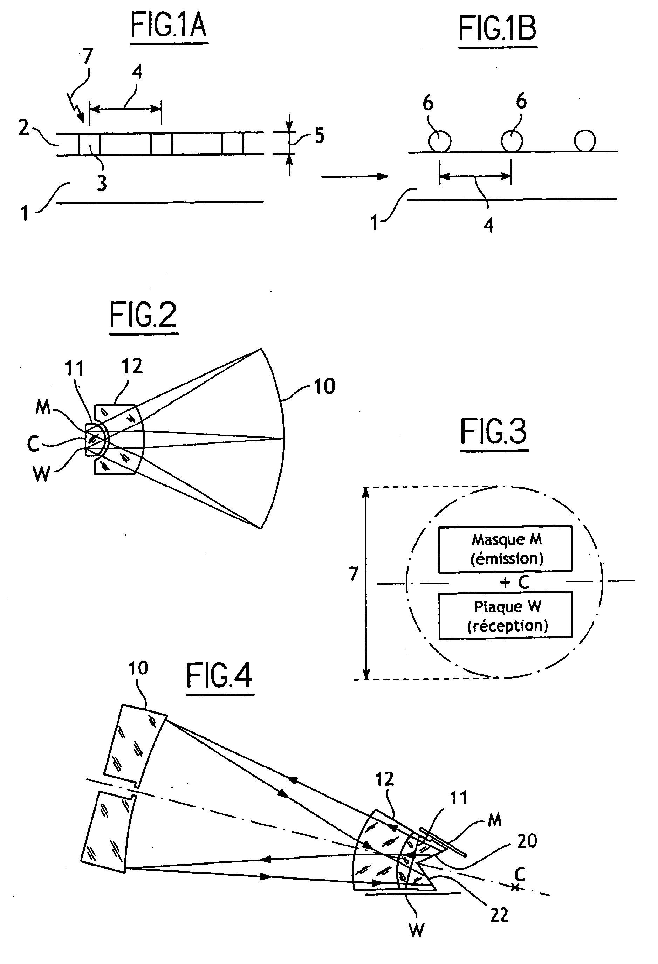

La technique utilisée pour la fabrication des plots est schématiquement représentée sur les figures 1A et 1B. Lors d'une première série d'étapes connues, on illumine grâce à un rayonnement 7 issu d'un illuminateur d'un dispositif de photolithographie, généralement à grandissement unitaire pour disposer d'un grand champ de travail, une couche 2 de résine située sur une plaque 1 de circuit (ou « wafer » selon la terminologie généralement utilisée par l'homme du métier). L'illumination ne s'effectue qu'au droit de certaines zones grâce à un masque, de sorte que des zones 3 sont évidées de résine par un traitement spécifique pour être remplies d'un matériau apte à former les plots de soudure. Il s'agit généralement d'or (on parle alors de « gold bumping »). Une autre série d'étapes également connues permettent d'obtenir le circuit représenté à la figure 1B, à savoir une plaque 1 sur laquelle sont disposés des plots de soudure 6 sensiblement sphériques.

La distance 4 séparant deux plots 6 est généralement comprise entre 50 et 500 µm. Ainsi, le dispositif de photolithographie utilisé pour cette application ne requiert pas de grandes précisions ni de grandes résolutions en comparaison des dispositifs de photolithographie de pointe de la technologie actuelle qui permettent, on le rappelle, des résolutions de l'ordre du dixième de µm. Une résolution de l'ordre de 2 µm et une distorsion maximale de 0.3 µm sont suffisantes pour les applications visées.

La couche 2 de résine est d'une épaisseur 5 de 100 µm environ. Le dispositif doit donc avoir une grande profondeur de champ, de l'ordre de 50 à 100 µm.

Enfin, les circuits électroniques de ce type doivent pouvoir être produits à une échelle industrielle avec la meilleure productivité. Le dispositif doit donc avoir un champ le plus grand possible pour pouvoir illuminer le plus de plaques possibles dans un temps donné et/ou la plus grande surface possible d'une plaque donnée. Le dispositif doit aussi pouvoir s'adapter à plusieurs types de lampes d'illumination hautes puissances utilisés par les industriels, notamment les raies spectrales g, h et i d'une lampe à mercure haute pression pour pouvoir utiliser le maximum de flux optique nécessaire à l'insolation des résines photosensibles.

En outre, il est extrêmement désirable en lithographie optique que les optiques soient télécentriques dans l'espace objet et l'espace image, comme préconisé par l'homme de l'art, c'est à dire que les cônes de rayons utiles soient bien perpendiculaires au plan objet et au plan image afin que le système ne transforme pas des erreurs de focalisation en des erreurs de positionnement latéral des images préjudiciables au recouvrement des dessin gravés lors des diverses étapes du processus lithographique.

### BUTS DE L'INVENTION ET PRESENTATION DE L'ART ANTERIEUR

Un but de l'invention est de proposer une structure optique de lithographie qui :
- présente un grandissement unitaire (recopie 1/1),
- est particulièrement adaptée pour des applications de moyenne résolutions (de 1 à quelques micromètres),
- permet un fonctionnement avec un champ important tout en étant télécentrique dans l'espace objet et image,
- tout en étant tout à la fois particulièrement compacte, peu chère et performante (en permettant notamment un fonctionnement avec les raies g, i et h d'une lampe à mercure).

On connaît déjà de nombreuses structures optiques de photolithographie qui ont été conçues et développées pour des applications de ce type.

Un premier exemple d'un tel dispositif est une structure du type « Dyson Winne » représentée schématiquement sur la figure 2. Il comporte un miroir sphérique concave 10 dont le centre de courbure est référencé par C. Le miroir 10 réfléchit des rayons lumineux issus d'un illuminateur (non représenté) et traversant un masque M pour les renvoyer vers certaines parties d'une plaque W pour créer les motifs désirés, par exemple des plots de soudure. Si M et W étaient tous les deux situés au centre C de courbure du miroir, l'image de M sur W serait optiquement parfaite, mais on comprend que le dispositif ne pourrait pas fonctionner car M et W devraient être physiquement confondus. Le dispositif comporte par conséquent des lentilles 11 et 12 présentant des surfaces concentriques au miroir 10 pour corriger les aberrations venant du fait que le masque M et la plaque W ne sont pas situés exactement sur le centre de courbure C du miroir sphérique 10 mais sont situés dans un même plan et légèrement décalés respectivement vers le haut et le bas par rapport à l'axe optique comme le montre la figure 3. Le dispositif de la figure 2 présente cependant l'inconvénient notamment que M et W sont situés dans un même plan, ce qui rend difficile leur déplacement relatif par des moyens d'actionnement lors de l'illumination. De plus, la largeur de champ 7 du dispositif est trop faible pour permettre d'illuminer des plaques de tailles compatibles avec des applications industrielles. Cette limitation des systèmes existants vient du fait que M et W doivent être situés à proximité du centre C du miroir 10 et des lentilles 11 et 12 de correction afin de pouvoir demeurer dans le champ utile optique circulaire et forcément limité à une certaine valeur en fonction des limitations de performance du dispositif type Dyson-Wynne.

Un deuxième exemple d'un dispositif connu est représenté à la figure 4. Il est d'une structure optique tout à fait similaire et comporte comme précédemment un miroir concave sphérique 10 et des lentilles 11 et 12 concentriques au miroir 10. La lentille 11 comporte cependant deux surfaces 20 et 22 réfléchissantes (également appelées « prismes de repliement » par l'homme du métier), de sorte que les rayons lumineux traversant le masque M et les rayons issus du miroir 10 pour illuminer la plaque W ne passent plus par le centre C du miroir 10 et des lentilles 11 et 12, mais soient repliés. Un tel repliement des rayons lumineux permet que M et W ne soient plus placés physiquement dans un même plan. On peut ainsi déplacer W dans un plan horizontal et M dans un plan oblique. Le plan horizontal comportant W et le plan oblique comportant M sont tangents au cône des rayons lumineux utiles qui se propagent entre le miroir concave 10 et le groupe de lentille 11 et 12 pour diminuer le champ pour lequel les lentilles 11 et 12 doivent introduire une correction. Les lentilles 11 et 12 étant concentriques au miroir 10, il faut en effet diminuer l'angle de champ avec lequel les rayons lumineux sont incidents sur les surfaces du miroir 10 et des lentilles 11 et 12. Le dispositif de la figure 4 présente cependant encore des inconvénients. Le fait que M soit situé dans un plan oblique engendre des difficultés pour son montage, son maintien et son déplacement mécanique. De plus, la largeur de champ du dispositif est encore trop faible pour permettre d'illuminer des plaques de tailles compatibles avec des applications industrielles car M et W sont encore trop proches l'un de l'autre et du centre C. Le dispositif de la figure 4 ne permet de corriger grâce aux lentilles 11 et 12 que de faibles aberrations, astigmatisme ou distorsion, car les rayons lumineux doivent rester autant que possible en incidence normale sur les surfaces du miroir 10 et des lentilles 11 et 12, puisqu'on désire que le dispositif reste autant que possible concentrique par rapport au centre du miroir C.

On connaît également par le document US 6.424.471 une structure optique de projection qui comporte un certain nombre de lentilles et un cube séparateur.

Outre que cette structure correspond à un grandissement ¼ et est destinée à des applications submicroniques, on relèvera qu'elle est particulièrement encombrante et utilise, pour minimiser les éventuelles aberrations, un cube séparateur à polarisation, ce qui complexifie la structure et contribue à augmenter son coût

On connaît par ailleurs par le document US 6.556.278 différentes solutions d'optique de lithographie à grandissement unitaire. Les solutions proposées dans ce document ne sont pas d'une compacité satisfaisante, ce document préconisant au contraire d'utiliser en combinaison une batterie de petites optiques pour obtenir un grand champ de fonctionnement.

Une autre solution d'optique à grandissement unitaire est encore proposée par le document US2003/0223127. Toutefois, la solution proposée dans ce document n'utilise pas de structure de type « Dyson-Winne » à miroir concave, mais une structure à miroir plan de renvoi. Elle ne pose pas les problèmes d'aberrations rencontrées avec les structures de type « Dyson-Winne », mais ne permet pas non plus les compacités qui peuvent être obtenues avec ces dernières.

Une autre solution d'optique à grandissement unitaire est proposée par le document US 4171871.

### PRESENTATION DE L'INVENTION

L'invention propose de pallier au moins un des inconvénients précités.

Elle propose en particulier un système optique à grandissement unitaire, télécentrique dans l'espace image et objet, pour application de lithographie moyenne résolution, comportant :
- une structure de type Dyson-Winne bien connue présentant un miroir concave sphérique travaillant pour un objet et une image passant par son centre de courbure et un bloc optique disposé au voisinage du centre de courbure dudit miroir,
caractérisé en ce qu'il comporte entre ledit miroir concave et ledit bloc optique
- d'un groupe convergent, constitué d'au moins deux lentilles, situé au voisinage dudit bloc optique et ayant une fonction de correcteur de champ et de réduction de dimension du miroir sphérique par convergence des rayons lumineux se propageant entre le miroir et le bloc optique et le groupe convergent,
- d'un groupe d'au moins deux autres lentilles, situé au voisinage du miroir concave et ayant pour fonction la correction d'ouverture et de chromatisme, - le champ image total est supérieur a 65% du diamètre du miroir concave.

Une telle structure à l'avantage de permettre un grand champ et d'améliorer significativement la compacité de l'optique, en même temps qu'elle permet la qualité d'image recherchée.

Notamment, elle permet un champ image supérieur à 70% du diamètre du miroir concave.

D'autres caractéristiques, buts et avantages de l'invention ressortiront de la description qui suit. Notamment, la solution décrite permet, du fait de l'accroissement du champ d'écarter l'un de l'autre les supports du masque et de la plaque pour une implantation machine plus aisée. Le champ étendu permet aussi d'illuminer une plus grande surface de plaque à chaque exposition et d'augmenter le rendement du dispositif.

De plus, les supports du masque et de la plaque peuvent être parallèles à l'axe optique du système. Le montage, le maintien et le déplacement du masque et de la plaque sont donc grandement facilités et les moyens de support sont donc moins difficiles à concevoir et moins onéreux. De par l'écartement des moyens de support, il est possible de dégager ces derniers des autres éléments optiques du système, ce qui améliore encore la facilité de montage et de déplacement libre du masque et de la plaque.

### PRESENTATION DES FIGURES

- les figures 1A et 1B, déjà commentées, représentent schématiquement une technique connue pour la fabrication de plots de soudure ;
- la figure 2, déjà commentée, représente schématiquement un premier exemple d'un mode de réalisation connu d'un système optique de photolithographie ;
- la figure 3, également déjà commentée, représente schématiquement une vue du champ optique d'un système de photolithographie de grandissement unitaire et de type Dyson-Winne;
- la figure 4, déjà commentée, représente schématiquement un deuxième exemple d'un mode de réalisation connu d'un système optique de photolithographie de grandissement unitaire;
- les figures 5 et 6 illustrent schématiquement deux modes de réalisation possibles d'un système optique conforme à l'invention.

Sur l'ensemble des figures, les éléments similaires portent des références numériques identiques.

### DESCRIPTION DETAILLEE D'UN OU PLUSIEURS EXEMPLES DE REALISATION

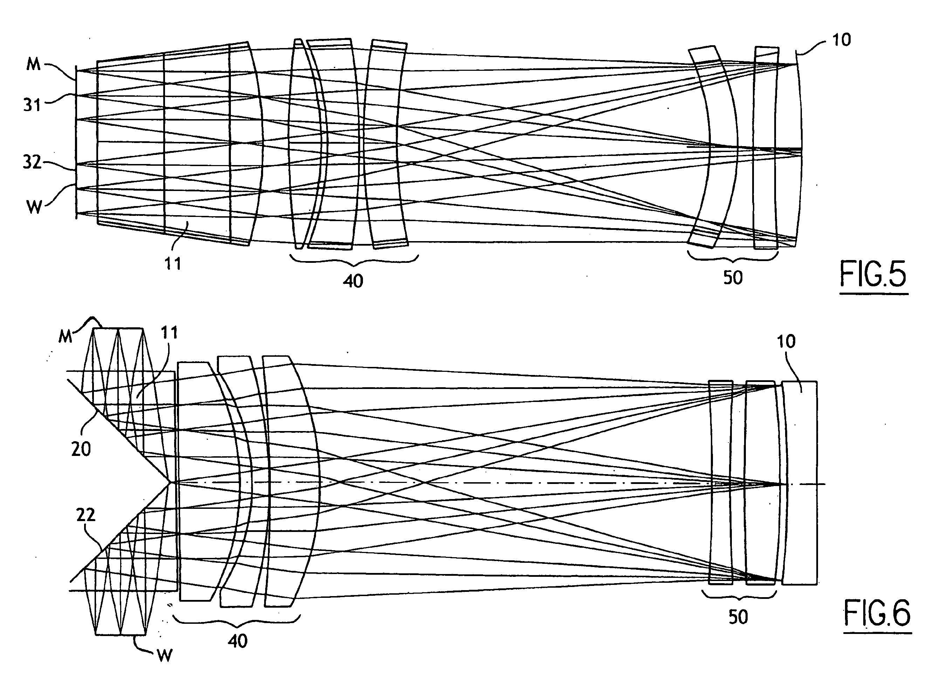

Les figures 5 et 6 représentent schématiquement deux exemples de modes de réalisation possibles d'un système optique d'un dispositif de photolithographie selon l'invention. D'autres modes de réalisation sont possibles et non représentés.

La figure 5 présente un système sans les prismes permettant de capter les rayons issus du masque M et de les renvoyer vers la plaque W. La figure 6 présente un système selon un mode de réalisation pratique plus abouti avec les 2 prismes de renvoi.

Principalement, le système optique présente une structure télécentrique de type Dyson Winne bien connue de l'homme de l'art, avec un miroir concave sphérique 10 travaillant pour un objet et une image placés au voisinage de son centre de courbure et le bloc optique 11 selon le concept Dyson-Winne constitué principalement d'une lentille épaisse avec une dioptre dont le centre de courbure est placé au voisinage du centre de l'objet.

Il comporte en outre un groupe 40 constitué d'au moins deux lentilles situé au voisinage dudit bloc optique 11 et ayant une fonction de correcteur de champ et de convergence des faisceaux pour réduire la dimension dudit miroir 10, ainsi qu'un groupe 50 d'au moins deux autres lentilles, situé au voisinage du miroir concave 10 et ayant pour fonction la correction d'ouverture et de chromatisme. Les verres constituant les lentilles des 2 groupes 40 et 50 sont sélectionnés selon les règles de l'art du calcul des combinaisons optiques pour assurer la correction chromatique sur le domaine spectral souhaité.

Il comporte également des moyens 31 et 32 de support aptes à recevoir et maintenir d'une part un masque M et une plaque W d'autre part. Les moyens 31 sont conçus pour s'adapter au masque M et les moyens 32 sont conçus pour s'adapter à la plaque W.

Les moyens de correction que constituent les groupes 40 et 50 sont situés optiquement entre les moyens 31 et 32 de support et le miroir 10. Autrement dit, des rayons lumineux, issus d'un illuminateur d'un dispositif de photolithographie et traversant le masque M situé sur les moyens 31, passent par les moyens de correction avant d'être réfléchis par le miroir 10 pour retraverser les moyens de correction et illuminer la plaque W sur les moyens 32.

La puissance réfractive du groupe 40 est ajustée pour que le rayon lumineux le plus éloigné de l'axe optique chemine quasiment parallèle à l'axe optique entre les 2 groupes optiques 40 et 50. De cette façon les dimensions totales de l'optique sont judicieusement minimisées ainsi que les coûts des matières optiques et de leur usinage et polissage.

La puissance réfractive totale du groupe 50 est faible et typiquement inférieure à 50% de la puissance réflective du miroir 10. Dans les dispositifs de l'art antérieur, les moyens de support et les lentilles de correction étaient situés à proximité immédiate du centre de courbure du miroir notamment comme le montre la figure 6, le bloc optique 11 peut comporter un prisme de repliement apte à replier des faisceaux lumineux issus du masque M ou émis vers la plaque W. Le prisme de repliement se présente sous la forme de deux surfaces 20 et 22 taillées dans le bloc 11, ces deux surfaces 20 et 22 s'étendant à 45° par rapport à l'axe principal du miroir concave. Les rayons lumineux traversant le masque M ou illuminant la plaque W sont donc repliés, ce qui permet le fait que les moyens de support 31 et 32 s'étendent sensiblement selon un axe parallèle à un axe optique du système. Bien entendu, les moyens de support 31 et 32 sont agencés de sorte que le masque M et la plaque W puissent également s'étendre sensiblement selon un axe parallèle à un axe optique du système. La conception et le maintien de la plaque et du masque dans des plans horizontaux sont grandement facilités par rapport aux dispositifs selon l'art antérieur.

Les moyens de support 31 et 32 comportent en outre des moyens 33 aptes à déplacer le masque M et/ou la plaque W selon une direction sensiblement parallèle à l'axe optique du système.

L'un des avantages de l'invention est que l'on peut concevoir l'optique objet de la présente invention de sorte que la distance des moyens 31 et 32 de support à l'axe optique du système est supérieure à l'encombrement radial du miroir 10 et des moyens 11, 40 et 50.

On dégage ainsi de l'espace pour le déplacement libre des moyens de support.

En même temps, la structure permet un fonctionnement grand champ tel que 44*44 mm², au lieu des 22*44 mm² constatés dans l'état de l'art antérieur, avec une optique demeurant très compacte. Cette compacité est caractérisée par la dimension du champ objet et image supérieure à 65 % du diamètre du plus grand élément optique de la formule, généralement constitué par le miroir concave dans la formule type Dyson Wynne.

Les lentilles des groupes 40 ou 50 sont par exemple avantageusement réalisées en incluant des surfaces asphériques.

Le système selon la figure 5 comporte un miroir sphérique 10, à proximité duquel est placé un groupe 50 constitué de 2 lentilles. Le groupe 40 est, lui, constitué de 3 lentilles. L'ouverture numérique utile est NA = 0.18. Du champ image, on peut extraire des zones de 44 x 44 m² pour le masque et la plaque. La résolution fournie par cette optique est de 2 µm sur toute cette surface pour un domaine spectral couvrant les trois raies g (435 nm), h (405 nm) et i (365 nm) des lampes à arc haute pression au Mercure.

Le système selon la figure 6 comprend les prismes de renvoi de la lumière vers le maque M et la plaque W. Le groupe 40 n'est constitué que de 2 lentilles. Les performances sont très voisines de celles du système de la figure 5 mais légèrement inférieures.

Sur la figure 6, le bloc optique 11 est un prisme à surface de réflexion, tandis que la figure 5 illustre une variante dans laquelle le bloc optique ne comporte pas de surface de réflexion, le masque d'émission et la plaque de réception étant tous deux dans un plan perpendiculaire à l'axe optique général, c'est-à-dire à l'axe du miroir sphérique 10.

Dans ces deux exemples, le champ image circulaire encerclant les zones utiles pour le masque M et la plaque W selon le concept présenté en figure 3 est d'un diamètre supérieur à 65% du diamètre du miroir concave 10, tandis que le miroir concave, le bloc optique et les différentes lentilles sont répartis dans une enveloppe sensiblement cylindrique pour la meilleure compacité du système et l'implantation la plus aisée dans la machine de lithographie.

Le diamètre intérieur de ce cylindre est inférieur à 250 mm, tandis que sa longueur intérieure est inférieure à 750 mm.

Les longueurs d'onde de fonctionnement sont comprises entre 360 et 435 nm.

## Revendications

1. Système optique à grandissement unitaire, télécentrique dans l'espace image et objet, pour application de lithographie moyenne résolution, comportant :
- une structure de type Dyson-Winne présentant un miroir concave sphérique (10) travaillant pour un objet (31) et une image (32) passant par son centre de courbure et un bloc optique (11) disposé au voisinage du centre de courbure dudit miroir,
comportant entre ledit miroir concave et ledit bloc optique
- un groupe d'au moins deux lentilles (40), situé au voisinage dudit bloc optique et ayant une fonction de correcteur de champ et de confinement des faisceaux dans un volume réduit,
- un groupe d'au moins deux autres lentilles (50), situé au voisinage direct du miroir concave et ayant pour fonction principale la correction des aberrations d'ouverture et de chromatisme,
système **caractérisé en ce que** le champ image total est supérieur à 65% du diamètre du miroir concave.

2. Système optique selon la revendication précédente, **caractérisé en ce que** le miroir concave, le bloc optique et les différentes lentilles sont répartis dans une enveloppe sensiblement cylindrique.

3. Système optique selon l'une des revendications précédentes, **caractérisé en ce que** le masque et la plaque à lithographier se déplacent selon des plans parallèles et que le bloc optique comprend des surfaces de réflexion s'étendant à 45° par rapport à l'axe du miroir concave afin de recueillir la lumière issue du masque et de renvoyer le faisceau image vers le plaque.

4. Système optique selon l'une des revendications précédentes, **caractérisé en ce qu'**au moins une des lentilles est de type asphérique.

5. Système selon l'une des revendications précédentes, dans lequel le miroir (10) est du type miroir de Mangin, constitué d'un traitement réfléchissant appliqué sur la face arrière d'une lentille.

## Claims

1. An optical system with unit magnification, image-space and object-space telecentric, for applying lithography of medium resolution, comprising:
- a structure of Dyson-Winne type having a spherical concave mirror (10) working for an object (31) and an image (32) passing through its centre of curvature, and an optical block (11) arranged in the vicinity of the centre of curvature of the said mirror,
comprising between said concave mirror and said optical block:
- a group of at least two lenses (40) located in the vicinity of the said optical block and having a function of field correction and of confining the beams within a reduced volume,
- a group of at least two other lenses (50) located in the direct vicinity of the concave mirror and having as main function the correction of aperture and chromatic aberrations,
the system being **characterized in that** the total image field is larger than 65% of the diameter of the concave mirror.

2. The optical system according to the preceding claim, **characterized in that** the concave mirror, the optical block and the different lenses are distributed within a substantially cylindrical casing.

3. The optical System according to one of the preceding claims, **characterized in that** the mask and the wafer to be lithographed move along parallel planes and **in that** the optical block comprises reflection surfaces extending at 45° relative to the axis of the concave mirror to collect the light originating from the mask and to send the image beam towards the wafer.

4. The optical system according to one of the preceding claims, **characterized in that** at least one of the lenses is of spherical type.

5. The system according to one of the preceding claims, wherein the mirror (10) is of Mangin mirror type formed by reflective treatment applied to the rear surface of a lens.

## Patentansprüche

1. Optisches System mit einheitlicher Vergrößerung, das im Bildraum und Objektraum telezentrisch ist, für die Anwendung in der Lithographie mit einer mittleren Auflösung, umfassend
- eine Struktur vom Typ Dyson-Winne mit einem sphärischen Hohlspiegel (10), der für ein Objekt (31) und ein Bild (32) arbeitet, die durch seine Krümmungsmitte verlaufen, und mit einem optischen Block (11), der in der Nähe der Krümmungsmitte des Spiegels angeordnet ist,
umfassend zwischen dem Hohlspiegel und dem optischen Block
- eine Gruppe von mindestens zwei Linsen (40), die sich in der Nähe des optischen Blocks befindet und eine Funktion der Feldkorrektur und der Begrenzung der Lichtstrahlen auf einen reduzierten Raum hat,
- eine Gruppe von mindestens zwei weiteren Linsen (50), die sich in der unmittelbaren Nähe des Hohlspiegels befindet und deren Hauptfunktion die Korrektur von Öffnungsfehlern und Farbfehlern ist,
wobei das System **dadurch gekennzeichnet ist, dass** das Gesamtbildfeld größer als 65% des Durchmessers des Hohlspiegels ist.

2. Optisches System nach dem vorhergehenden Anspruch, **dadurch gekennzeichnet, dass** der Hohlspiegel, der optische Block und die unterschiedlichen Linsen in einem im Wesentlichen zylindrischen Gehäuse verteilt sind.

3. Optisches System nach einem der vorhergehenden Ansprüche, **dadurch gekennzeichnet, dass** die Lithographiemaske und die Lithographieplatte sich in parallelen Ebenen bewegen und dass der optische Block Reflektionsflächen umfasst, die sich in einem Winkel von 45° relativ zu der Achse des Hohlspiegels erstrecken, um das von der Maske ausgehende Licht einzufangen und den Bildlichtstrahl in Richtung der Platte umzulenken.

4. Optisches System nach einem der vorhergehenden Ansprüche, **dadurch gekennzeichnet, dass** zumindest eine der Linsen vom asphärischen Typ ist.

5. System nach einem der vorhergehenden Ansprüche, wobei der Spiegel (10) vom Typ Mangin-Spiegel ist, der durch eine Reflektionsbehandlung gebildet ist, die auf die Rückseite einer Linse angewendet wird.
